# EUROPEAN PATENT APPLICATION

(11) **EP 2 009 139 A1**
(43) Date of publication of application: **31.12.2008**
(21) Application number: 08158575.4
(22) Date of filing: 19.06.2008
(51) Int. Cl.: C23C 16/455, C23C 16/34, H01L 21/285

(54) **Cyclic Deposition Method for Depositing a Metal Silicon Nitride Film**

(30) Priority: 19.06.2007 KR 20070059991
(71) Applicant: Air Products and Chemicals, Inc., Allentown, PA 18195-1501 (US)
(72) Inventor: Kim, Min-Kyung, Suwon-si (KR); Kim, Moo-Sung, Sungnam-City (KR); Yang, Sang-Hyun, Suwon-City (KR); Lei, Xinjian, Vista, CA 92081 (US)
(74) Representative: Muir, Benjamin M. J.

(57) **Abstract**

The present invention relates to a method for forming a metal silicon nitride film according to a cyclic film deposition under plasma atmosphere with a metal amide, a silicon precursor, and a nitrogen source gas as precursors. The deposition method for forming a metal silicon nitride film on a substrate comprises steps of: pulsing a metal amide precursor; purging away the unreacted metal amide; introducing nitrogen source gas into reaction chamber under plasma atmosphere; purging away the unreacted nitrogen source gas; pulsing a silicon precursor; purging away the unreacted silicon precursor; introducing nitrogen source gas into reaction chamber under plasma atmosphere; and purging away the unreacted nitrogen source gas.

## Description

### BACKGROUND OF THE INVENTION

The present invention relates to a method for forming a metal silicon nitride film according to a cyclic film deposition under plasma atmosphere with a metal amide, a silicon precursor, and a nitrogen source gas as precursors.

Phase change memory (PRAM) devices use phase change materials that can be electrically switched between an amorphous and a crystalline state. Typical materials suitable for such an application include various chalcogenide elements such as germanium, antimony and tellurium. In order to induce a phase change, a chalcogenide material should be heated up by a heater. There are many potential heating materials such as titanium nitride (TiN), titanium aluminium nitride (TiAIN), titanium silicon nitride (TiSiN), tantalum silicon nitride (TaSiN), and so on.

The widely studied deposition techniques for preparing those films are a physical vapor deposition (PVD), i.e., a sputtering, and a chemical vapor deposition (CVD) technique generally using organometallic precursors. As semiconductor devices shrink, a heating material may be deposited on a substrate with a high-aspect ratio structure depending on the design of device integration.

With the trend, the sputtering methods have been found inadequate for forming a film with a uniform thickness. CVD is typically used to form a uniform film thickness but generally fails to meet the requirement of good step coverage in high-aspect ratio structure devices. It is known that the deposited metal nitride films have bad step coverage due to the reaction between gaseous alkylamido metal compound and ammonia gas, particularly in the case of using an alkylamido metal precursor to chemically deposit metal nitride films. Unlike conventional chemical deposition methods in which precursors are simultaneously supplied on a substrate, atomic layer deposition (ALD) in which precursors are sequentially supplied on a substrate is considered as a promising technique for producing a uniform thickness film even in a high-aspect ratio structure because of its unique characteristic of providing self-limiting reaction control.

In ALD a chemical reaction occurs only between a precursor and the surface of a substrate. Interest has increased in studies for forming metal silicon nitride film using ALD techniques. One of them is how to prepare metal silicon nitride films using a metal halide precursor and silane under N₂/H₂ plasma atmosphere. Because of a need for the usage of plasma, it is called a plasma-enhanced Atomic Layer Deposition (PEALD). Another example of ALD for forming metal silicon nitride films is to use a metal amide precursor, silane, and ammonia. Using a metal chloride precursor, a silicon source such as silane, and ammonia, a very high temperature process up to about 1000°C is required which makes this process undesirable for use with certain substrates.

The present inventors have discovered that if a metal amide precursor, a silicon precursor, and a nitrogen source gas are used for forming a metal silicon nitride film, a film can be formed at a much lower deposition temperature than CVD using a metal halide precursor. Also, the inventors have discovered that if plasma is used for cyclic deposition of a film, the film growth rate can be significantly increased and a metal silicon nitride film, which can be grown at a low deposition temperature, can be provided.

### BRIEF SUMMARY OF THE INVENTION

In one aspect, the invention provides a cyclic deposition method of three-component metal silicon nitride films under plasma atmosphere.

In another aspect, the invention provides an improved cyclic deposition of films by using preferred precursors under plasma atmosphere.

In another aspect, the invention provides a deposition method for forming a metal silicon nitride film on a substrate, the method comprising steps of:
a) introducing a metal amide in a vapor state into a reaction chamber and then chemisorbing the metal amide onto a substrate which is heated;
b) purging away the unreacted metal amide;
c) introducing a nitrogen source gas into the reaction chamber under plasma atmosphere to make metal (M) - N bonds;
d) purging away the unreacted nitrogen source gas;
e) introducing a silicon precursor in a vapor state into the reaction chamber to make N - Si bonds;
f) purging away the unreacted silicon precursor;
g) introducing a nitrogen source gas into the reaction chamber under plasma atmosphere to make Si - N bonds; and
h) purging away the unreacted nitrogen source gas.

In an embodiment of the above aspect, the steps are performed in the order of e → f → g → h → a → b → c → d.

In a further aspect, the invention provides a deposition method for forming a metal silicon nitride film on a substrate, the method comprising steps of:
a) introducing a metal amide in a vapor state into a reaction chamber under plasma atmosphere and then chemisorbing the metal amide onto a substrate which is heated;
b) purging away the unreacted metal amide;
c) introducing a silicon precursor in a vapor state into the reaction chamber under plasma atmosphere to make a bond between the metal amide adsorbed on the substrate and the silicon precursor; and
d) purging away the unreacted silicon precursor.

### BRIEF DESCRIPTION OF THE DRAWINGS

FIG. 1 is a graph showing the resistivities and Ti/Si atomic ratio of TiSiN films deposited at temperatures of 450°C and 250°C during plasma enhanced cyclic deposition using as precursors TDMAT and BTBAS, dependent upon the pulsing time ratio of the precusors.
FIG. 2 is a graph showing film deposition rates for plasma enhanced cyclic deposition of a TiSiN films, at temperatures of 450°C and 250°C, using TDMAT and BTBAS.
FIG. 3 is a graph showing sheet resistance per the number of deposition cycles for plasma enhanced cyclic deposition of a TiSiN film using TDMAT and BTBAS at 450° C.

### DETAILED DESCRIPTION OF THE INVENTION

The present invention provides a method for forming a metal silicon nitride film by using a metal amide, a silicon precursor, and a nitrogen source gas as precursors under plasma atmosphere according to a cyclic deposition of films.

In an embodiment, the deposition method for forming a metal silicon nitride film according to the present invention comprises steps of:
a) introducing a metal amide in a vapor state into a reaction chamber and then chemisorbing the metal amide onto a substrate which is heated;
b) purging away the unreacted metal amide;
c) introducing a nitrogen source gas into the reaction chamber under plasma atmosphere to make metal (M) - N bonds;
d) purging away the unreacted nitrogen source gas;
e) introducing a silicon precursor in a vapor state into the reaction chamber to make N - Si bonds;
f) purging away the unreacted silicon precursor;
g) introducing a nitrogen source gas into the reaction chamber under plasma atmosphere to make Si - N bonds; and
h) purging away the unreacted nitrogen source gas.

Also, in the cycle of this invention, the metal amide may be introduced after the silicon precursor is introduced. In this case, the steps may be performed in the order of e → f → g → g → h → a → c → d.

In another embodiment, the invention provides a deposition method for forming a metal silicon nitride film comprises steps of:
a) introducing a metal amide in a vapor state into a reaction chamber under plasma atmosphere and then chemisorbing the metal amide onto a substrate which is heated;
b) purging away the unreacted metal amide;
c) introducing a silicon precursor in a vapor state into the reaction chamber under plasma atmosphere to make a bond between the metal amide adsorbed on the substrate and the silicon precursor; and
d) purging away the unreacted silicon precursor.

The above steps define one cycle for the present methods, and the cycle can be repeated as necessary until the desired thickness of a metal silicon nitride film is obtained.

Whilst metal silicon nitride films can be prepared by a standard thermal ALD, by depositing films under plasma atmosphere the film growth rate of metal silicon nitride film process can be significantly increased because plasma activation increases the reactivity of reactants.

For example, the sheet resistance of TiSiN films obtained by the PEALD process of the invention is about two-orders lower than that obtained by thermal ALD. Additionally, the PEALD process enhances the film properties and widens the process window. That makes it easier to meet the required film specifications for targeting applications.

In one embodiment of the present invention, a first precursor onto a substrate for the present deposition method is a metal amide.

Metals commonly used in semiconductor fabrication and suitable as the metal component of the metal amide include: titanium, tantalum, tungsten, hafnium, and zirconium. Specific examples of metal amides suited for use in the present deposition methods include tetrakis(dimethylamino)titanium (TDMAT), tetrakis(diethylamino)titanium (TDEAT), tetrakis(ethyl-methyl-amino)titanium (TEMAT), tert-Butylimino tri(diethylamino)tantalum (TBTDET), tert-butylimino tri(dimethylamino)tantalum (TBTDMT), tert-butylimino tri(ethyl-methylamino)tantalum (TBTEMT), ethylimino tri(diethylamino)tantalum (EITDET), ethylimino tri(dimethylamino)tantalum (EITDMT), ethylimino tri(ethylmethylamino)tantalum (EITEMT), tert-amylimino tri(dimethylamino)tantalum (TAIMAT), tert-amylimino tri(diethylamino)tantalum (TAIEAT), pentakis(dimethylamino)tantalum (PDMAT), tert-amylimino tri(ethylmethylamino)tantalum (TAIEMAT), bis(tert-butylimino)bis(dimethylamino)-tungsten (BTBMW), bis(tert-butylimino)bis(diethylamino)tungsten (BTBEW), bis(tert-butylimino)bis(ethylmethylamino)tungsten (BTBEMW), tetrakis(dimethyl-amino)zirconium (TDMAZ), tetrakis(diethylamino)zirconium (TDEAZ), tetrakis-(ethylmethylamino)zirconium (TEMAZ), tetrakis(dimethylamino)hafnium (TDMAH), tetrakis(diethylamino)hafnium (TDEAH), tetrakis(ethylmethyl-amino)hafnium (TEMAH), and mixtures thereof. More preferably, tetrakis-(dimethylamino)titanium (TDMAT) may be used for the metal amide.

The metal amide is supplied to the reaction chamber at a predetermined molar volume and for a predetermined time. Typically, the metal amide is supplied to a CVD or ALD chamber for a period of 0.1 to 500 seconds to allow the material to be sufficiently adsorbed so as to saturate a surface. During deposition, the metal amide is preferably in the gas phase and supplied in a predetermined molar volume, for example in the range of 0.1 to 1000 micromoles.

The silicon precursors suitable for the present invention may contain preferably both N-H and Si-H bonds.

The silicon precursors may be one or more compounds selected from a monoalkylamino silane having formula (1) and a hydrazinosilane having formula (2):

(R¹NH)ₙSiR²ₘH₄₋ₙ₋ₘ (1)

(R³₂N-NH)ₓSiR⁴_{y}H₄₋ₓ₋ᵥ (2)

wherein in the above formulae, R¹ to R⁴ are the same or different and are independently selected from alkyl, vinyl, allyl, phenyl, cyclic alkyl, fluoroalkyl, and silylalkyls, and n = 1, 2, or 3; m = 0, 1, or 2; n + m ≤ 3, x=1, 2, or 3; y = 0, 1, or 2; and x + y ≤ 3.

"Alkyl" in the above formulae refers to optionally substituted, linear or branched hydrocarbon which has 1-20 carbon atoms, preferably 1-10 carbon atoms, and more preferably 1-6 carbon atoms.

The monoalkylamino silane and hydrazinosilane suitable for the present invention may preferably be selected from bis(tert-butylamino)silane (BTBAS), tris(tert-butylamino)silane, bis(iso-propylamino)silane, tris(iso-propylamino)silane, bis(1,1-dimethylhydrazino)-silane, tris(1,1-dimethylhydrazino)silane, bis(1,1-dimethylhydrazino)ethylsilane, bis(1,1-dimethylhydrazino)isopropylsilane, bis(1,1-dimethylhydrazino)vinylsilane, and mixture thereof. More preferably, bis(tert-butylamino)silane (BTBAS) may be used.

Conventionally, monoalkylaminosilanes and hydrazinosilanes have been investigated for depositing silicon nitride films irrespective of the use of ammonia. Since in certain embodiments ammonia is introduced into the reactor, which can also be referred to as "reaction chamber", the present invention can further increase the combination of metal amides and the silicon precursors to prepare metal silicon nitride films. Certain metal amides and monoalkylaminosilanes suitable for this invention are known to react with each other in either liquid form or the gas phase, and thus are not suited for use in traditional CVD techniques.

The silicon precursor is introduced into the reactor at a predetermined molar volume, for example 0.1 to 1000 micromoles, for a predetermined time period, for example 0.1 to 500 seconds. The silicon precursor reacts with the metal amide and is adsorbed onto the surface of the substrate resulting in the formation of an adorbed silicon nitride having a metal-nitrogen-silicon linkage.

The nitrogen source gas suitable for the present invention may be a suitable nitrogen precursor selected from ammonia, hydrazine, monoalkylhydrazine, dialkylhydrazine, and mixture thereof.

The nitrogen source gas, such as ammonia, may if used be introduced into the reactorat, for example, a flow rate of 10 to 2000 sccm, for 0.1 to 1000 seconds.

The purge gas, used in the step of purging away unreacted precursors, is an inert gas that does not react with the precursors and may preferably be selected from Ar, N₂, He, H₂ and mixture thereof.

Generally, the purge gas, such as Ar, is supplied into the reactor at, for example, a flow rate of 10 to 2000 sccm for 0.1 to 1000 seconds, thereby purging the unreacted material and any byproducts that remain in the chamber.

The metal silicon nitride generated according to the present invention may be titanium silicon nitride, tantalum silicon nitride, tungsten silicon nitride, hafnium silicon nitride, or zirconium silicon nitride.

The deposition used in this invention may be a cyclic chemical vapor deposition process or an atomic layer deposition process, the process adopted depending on the process conditions, in particular the deposition temperatures.

Film growth according to ALD is performed by alternately exposing the substrate surface to the different precursors. It differs from CVD by keeping the precursors strictly separated from each other in the gas phase. In an ideal ALD window, where film growth is controlled by self-limiting control of the surface reaction, the duration for which each precursor is introduced as well as the deposition temperature have no effect on the growth rate if the surface is saturated.

The cyclic CVD (CCVD) process can be performed at a higher temperature range than the ALD window, at which temperatures precursor decomposition occurs. The so called 'CCVD' is different from the traditional CVD in terms of precursor separation. Each precursor is sequentially introduced and totally separated in the CCVD process, whereas in the traditional CVD process all reactant precursors are simultaneously introduced to the reactor and induced to react with each other in the gas phase. The common point of the CCVD and the traditional CVD processes is that both are related to the thermal decomposition of precursors.

The temperature of the substrate in the reactor, i.e., a deposition chamber, may preferably be below 600°C and more preferably below 500°C, and the process pressure may preferably be from 0.1 Torr (13 Pa) to 100 Torr (13 kPa), and more preferably from 1 Torr (130 Pa) to 10 Torr (1.3 kPa).

The respective step of supplying the precursors and the nitrogen source gases may be performed by changing the time for supplying them to change the stoichiometric composition of the three-component metal silicon nitride film.

The plasma-generated process comprises a direct plasma-generated process in which plasma is directly generated in the reactor, or a remote plasma-generated process in which plasma is generated out of the reactor and supplied into the reactor.

The first benefit of the present invention is that the ALD process is assisted by plasma enhancement, which makes a deposition temperature much lower, so a thermal budget can be lowered. At the same time, the ALD process makes it possible to have a wider process window to control the specifications of film properties required in targeting applications.

The other benefit of the present invention is the possibility of employing monoalkylaminosilanes or hydrazinosilanes as a silicon source. Currently, silane, ammonia gas and metal amides have been investigated to form metal silicon nitride films, wherein silane is a pyrophoric gas, implying a potential hazard. By comparison, monoalkylaminosilanes or hydrazinosilanes as may be used in the present invention are not pyrophoric, and therefore is less hazardous to use.

In one preferred embodiment of the present invention, a plasma enhanced cyclic deposition may be employed, wherein tetrakis(dimethylamino)titanium (TDMAT), bis(tert-butylamino)silane (BTBAS), and ammonia are used as the metal amide, silicon precursor and nitrogen source gas, respectively.

Exemplary embodiments of the present invention will be described in detail.

The gas lines connecting from the precursor canisters to the reaction chamber are heated to 70°C, and the containers of TDMAT and BTBAS are kept at room temperature. Said precursors are injected into the reaction chamber by bubbling argon through the liquid, with 25sccm of argon gas being used to carry the vapor of each precursor to the reaction chamber during pulsing of each precursor. 500sccm of argon gas continuously flows during the purging steps, and the reaction chamber process pressure is about 1Torr (130 Pa).

A silicon oxide wafer is used as a substrate, the thickness of which is more than 1000Å to completely isolate interference of a sub-silicon layer on the measurement of sheet resistance of the film. During the process, the silicon oxide wafer heated on a heater stage in the reaction chamber is exposed to the TDMAT initially such that the TDMAT precursor adsorbs onto the surface of silicon oxide wafer. Argon gas purges away unadsorbed excess TDMAT from the process chamber. After enough Ar purging, ammonia gas is introduced into reaction chamber whereby plasma is directly generated inside a chamber. The plasma activated ammonia replaces the dimethylamino ligands of the TDMAT adsorbed on the substrate forming a bond between titanium and nitrogen. Ar gas which follows then purges away unreacted excess NH₃ from the chamber. Thereafter, BTBAS is introduced into the chamber resulting in bond formation between nitrogen and silicon. Unadsorbed excess BTBAS molecules are purged away by the following Ar purge gas. Ammonia gas is then introduced into the chamber under plasma atmosphere and replaces one or more ligands of BTBAS by forming Si-N bonds. The surface treated by the ammonia gas provides new reaction sites for the following TDMAT introduction. Unreacted excess ammonia gas is purged away by Ar gas. The aforementioned steps define the typical cycle for the present three-chemical process. The process cycle can be repeated several times to achieve the desired film thickness.

TiSiN films as a heating material in a PRAM device require various specifications of film properties such as high resistivity, thermal stability in crystallinity, material compatibility with memory elements, and so on. The process parameters such as deposition temperature, precursor pulsing time, and RF power can vary to meet the required film properties.

The film composition (Ti/Si At.% Ratio) is dependent upon the quantity of TDMAT and BTBAS supplied into the process chamber. The quantity of TDMAT and BTBAS can vary by changing the pulsing time of each precursor and the temperature of the canisters of precursors.

### EXAMPLES

Hereinafter, the present invention will be described in more detail with referenced examples.

### Example 1. Preparation of titanium silicon nitride (TiSiN) films at 450°C by PEALD

The cycle was comprised of the sequential supply of TDMAT bubbled by an Ar carrier gas at a flow rate of 25sccm for various pulsing times; an Ar purge gas at a flow rate of 500sccm for 5 seconds; an ammonia gas at a flow rate of 100sccm for 5 seconds during RF plasma generation; an Ar purge gas at a flow rate of 500sccm for 5 seconds; BTBAS bubbled by an Ar carrier gas at a flow rate of 25sccm for various pulsing times; an Ar purge gas at a flow rate of 500sccm for 5 seconds; an ammonia gas at a flow rate of 100sccm for 5 seconds during RF plasma generation; and an Ar purge gas at a flow rate of 500sccm for 5 seconds. Process chamber pressure was about 1.0 Torr (130 Pa) and the heater temperature 450°C corresponded to a wafer temperature of 395°C.

Keeping the total TDMAT+BTBAS flow amount for each set of conditions the same (i.e. a total pulsing time of 3.5 seconds), the TDMAT/BTBAS pulsing times were changed from 0.5 seconds/3 seconds, to 1.75 seconds/1.75 seconds, and to 3 seconds/0.5 seconds, respectively. The ammonia pulsing time was kept constant for the saturation duration, 5 seconds, and 100 sccm of ammonia flowed directly into plasma-generated chamber in which the RF power was 50W. The cycle was repeated 100 times or more.

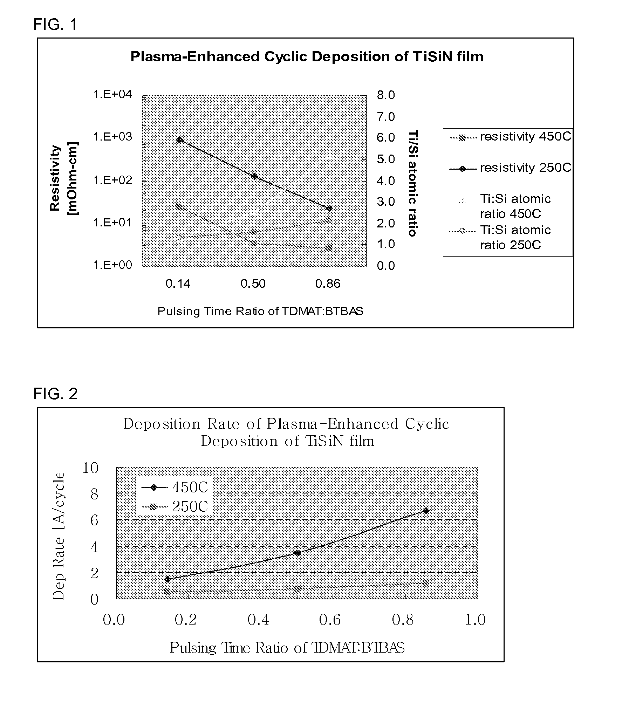

FIGS. 1 to 3 illustrate the results of the above tests.

As illustrated in FIG. 1, based on the resulting deposition rates for TDMAT and BTBAS, it seemed that TDMAT was more reactive than BTBAS in TiSiN film formation. The resistivities for the above conditions were 25.3, 3.4, and 2.6 mOhm-cm, respectively. Rutherford Backscattering Spectroscopy (RBS) analysis showed Ti/Si ratios of 1.3, 2.5, and 5.2, respectively.

Also, as illustrated in FIG. 2, the deposition rates for the above conditions were 1.4, 3.5, and 6.7Å/cycle, respectively, which reflected that the above conditions were outside of the ALD region.

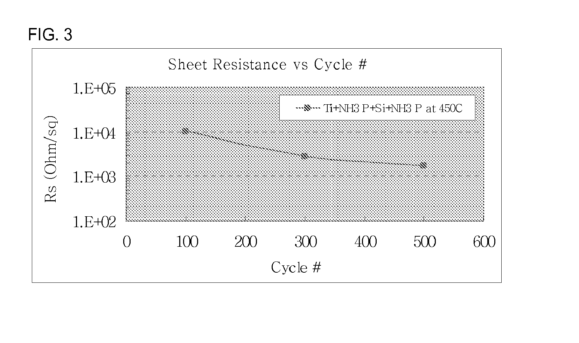

FIG. 3 illustrates sheet resistances depending on cycles, which correspond to the tendency that sheet resistances decrease as thickness increases.

### Example 2. Preparation of titanium silicon nitride (TiSiN) films at 250°C by PEALD

Except for the heater temperature being 250°C, the cycle was the same as that in above example 1. The heater temperature of 250°C corresponded to a wafer temperature of 235°C.

FIGS. 1 and 2 illustrate the results of the above test.

As illustrated in FIG. 1, the resistivities for the above conditions were 915.1, 123.5, and 22.5 mOhm-cm, respectively, and RBS analysis showed Ti/Si ratios of 1.3, 1.6, and 2.1, respectively.

Also, as illustrated in FIG. 2, the deposition rates for the above conditions were 0.6, 0.8, and 1.1 Å/cycle, respectively, which reflected that the above conditions were in the ALD region. In other words, metal silicon nitride films, which can be grown at a low process temperatures, can be provided.

### Example 3. Preparation of titanium silicon nitride (TiSiN) films at 250°C by the thermal ALD (Comparative Example)

The cycle was comprised of sequential supply of TDMAT bubbled by an Ar carrier gas at a flow rate of 25sccm for various pulsing times; an Ar purge gas at a flow rate of 500sccm for 5 seconds; an ammonia gas at a flow rate of 100sccm for 5 seconds without RF plasma generation; an Ar purge gas at a flow rate of 500sccm for 5 seconds; BTBAS bubbled by an Ar carrier gas at a flow rate of 25sccm for various pulsing times; an Ar purge gas at a flow rate of 500sccm for 5 seconds; an ammonia gas at a flow rate of 100sccm for 5 seconds without RF plasma generation; and an Ar purge gas at a flow rate of 500sccm for 5 seconds. Process chamber pressure was about 1.0 Torr (130 Pa), and the heater temperature of 250°C corresponded to a wafer temperature of 235°C.

Keeping the total TDMAT+BTBAS flow amount the same for each set of conditions (i.e. a total pulsing time of 3.5 seconds), the TDMAT/BTBAS pulsing times were changed from 0.5 seconds/3 seconds, to 1.75 seconds/1.75 seconds, and to 3 seconds/ 0.5 seconds, respectively. The ammonia pulsing time was kept constant for the saturation duration, 5 seconds, and 100 sccm of ammonia flowed directly into chamber. The cycle was repeated 100 times or more. However, no film formed on the silicon oxide substrate.

While the foregoing detailed description is directed to preferred embodiments of the present invention, other and further embodiments of the invention may be devised, and the scope of the invention is determined by the claims that follow.

As described above, the present invention uses plasma for cyclic deposition of films so that the growth rate of films can be significantly increased and metal silicon nitride films, which can be grown at a low process temperature, can be provided. Additionally, since the present invention uses the most suitable precursor compounds for cyclic deposition of films using plasma, the deposition efficiency of films can be maximized.

## Claims

1. A deposition method for forming a metal silicon nitride film on a substrate, the method comprising:
(i) introducing a metal amide in a vapor state into a reaction chamber to chemisorb the metal amide onto a heated substrate, followed by purging away the unreacted metal amide; and
(ii) introducing a silicon precursor in a vapor state into the reaction chamber to chemisorb the silicon precursor onto the substrate, followed by purging away unreacted silicon precursor;
wherein in step (i): the metal amide is introduced into the reaction chamber under plasma atmosphere; and/or after the unreacted metal amide has been purged away a nitrogen source gas is introduced into the reaction chamber under plasma atmosphere to make metal - N bonds, following which the unreacted nitrogen source gas is purged away;
wherein in step (ii): the silicon precursor is introduced into the reaction chamber under plasma atmosphere; and/or after the unreacted silicon precursor has been purged away a nitrogen source gas is introduced into the reaction chamber under plasma atmosphere to make Si - N bonds, following which the unreacted nitrogen source gas is purged away; and
wherein step (i) may be carried out before or after step (ii).

2. A deposition method according to claim 1, the method comprising steps of:
a) introducing a metal amide in a vapor state into a reaction chamber to chemisorb the metal amide onto a heated substrate;
b) purging away the unreacted metal amide;
c) introducing nitrogen source gas into the reaction chamber under plasma atmosphere to make metal - N bonds;
d) purging away the unreacted nitrogen source gas;
e) introducing a silicon precursor in a vapor state into the reaction chamber to make N - Si bonds;
f) purging away the unreacted silicon precursor;
g) introducing nitrogen source gas into the reaction chamber under plasma atmosphere to make Si - N bonds; and
h) purging away the unreacted nitrogen source gas.

3. A deposition method according to claim 1, the method comprising steps of:
a) introducing a silicon precursor in a vapor state into a reaction chamber to chemisorb the silicon precursor onto a heated substrate;
b) purging away the unreacted silicon precursor;
c) introducing nitrogen source gas into the reaction chamber under plasma atmosphere to make Si - N bonds;
d) purging away the unreacted nitrogen source gas;
e) introducing a metal amide in a vapor state into the reaction chamber to make N - metal bonds;
f) purging away the unreacted metal amide;
g) introducing nitrogen source gas into the reaction chamber under plasma atmosphere to make metal - N bonds; and
h) purging away the unreacted nitrogen source gas.

4. A deposition method according to claim 1, the method comprising steps of:
a) introducing a metal amide in a vapor state into a reaction chamber under plasma atmosphere to chemisorb the metal amide onto a heated substrate;
b) purging away the unreacted metal amide;
c) introducing a silicon precursor in a vapor state into the reaction chamber under plasma atmosphere to make a bond between the metal amide adsorbed on the substrate and the silicon precursor; and
d) purging away the unreacted silicon precursor.

5. The method of any one of claims 1 to 3, wherein the nitrogen source gas is selected from ammonia, hydrazine, monoalkylhydrazine, dialkylhydrazine, and mixture thereof.

6. The method of any preceding claim, wherein the metal silicon nitride is titanium silicon nitride, tantalum silicon nitride, tungsten silicon nitride, hafnium silicon nitride, or zirconium silicon nitride.

7. The method of any preceding claim, wherein the metal amide is selected from tetrakis(dimethylamino)titanium (TDMAT), tetrakis(diethylamino)titanium (TDEAT), tetrakis(ethylmethylamino)titanium (TEMAT), tert-Butylimino tri(diethylamino)tantalum (TBTDET), tert-butyl-imino tri(dimethylamino)tantalum (TBTDMT), tert-butylimino tri(ethyl-methylamino)tantalum (TBTEMT), ethylimino tri(diethylamino)tantalum (EITDET), ethylimino tri(dimethylamino)tantalum (EITDMT), ethylimino tri(ethylmethylamino)tantalum (EITEMT), tert-amylimino tri(dimethyl-amino)tantalum (TAIMAT), tert-amylimino tri(diethylamino)tantalum (TAIEAT), pentakis(dimethylamino)tantalum (PDMAT), tert-amylimino tri(ethylmethylamino)tantalum (TAIEMAT), bis(tert-butylimino)bis(dimethyl-amino)tungsten (BTBMW), bis(tert-butylimino)bis(diethylamino)tungsten (BTBEW), bis(tert-butylimino)bis(ethylmethylamino)tungsten (BTBEMW), tetrakis(dimethylamino)zirconium (TDMAZ), tetrakis(diethylamino)zirconium (TDEAZ), tetrakis(ethylmethyl-amino)zirconium (TEMAZ), tetrakis(dimethyl-amino)hafnium (TDMAH), tetrakis(diethylamino)hafnium (TDEAH), tetrakis-(ethylmethylamino)hafnium (TEMAH), and mixture thereof.

8. The method of any preceding claim, wherein the silicon precursor contains both N-H and Si-H bonds.

9. The method of claim 8, wherein the silicon precursor is one or more compounds selected from a monoalkylamino silanes having formula (1) and a hydrazinosilanes having formula (2):
(R¹NH)ₙSiR²ₘH₄₋ₙ₋ₘ (1)
(R³_{2N}-NH)ₓSiR⁴_{y}H_{4-x-y} (2)
wherein in the above formulae: R¹ to R⁴ are the same or different and are independently selected from alkyl, vinyl, allyl, phenyl, cyclic alkyl, fluoroalkyl, and silylalkyls; n = 1, 2, or 3; m = 0, 1, or 2; n + m ≤ 3; x=1, 2, or 3; y = 0, 1, or 2; and x + y ≤ 3.

10. The method of claim 9, wherein the silicon precursor is selected from bis(tert-butylamino)silane (BTBAS), tris(tert-butylamino)silane, bis(iso-propylamino)silane, tris(iso-propylamino)silane, bis(1,1-dimethylhydrazino)silane, tris(1,1-dimethylhydrazino)silane, bis(1,1-dimethylhydrazino)ethylsilane, bis(1,1-dimethylhydrazino)isopropylsilane, bis(1,1-dimethylhydrazino)vinylsilane, and mixture thereof.

11. The method of any preceding claim, wherein the purge gas used in the purging steps is selected from Ar, N₂, He, H₂ and mixture thereof.

12. The method of any preceding claim, wherein the deposition method is a cyclic chemical vapor deposition process or an atomic layer deposition process.

13. The method of any preceding claim, wherein the temperature of the substrate is below 600°C and the process pressure is from 13 Pa (0.1 Torr) to 13 kPa (100 Torr).

14. The method of any preceding claim, wherein the respective steps of supplying the metal amide, silicon precursor and, where present, the nitrogen source gas are carried out more than once, and the duration of supply of one or more of the metal amide, silicon precursor and nitrogen source gas is varied to change the stoichiometric composition of the three-component metal silicon nitride film.

15. The method of any preceding claim, wherein the plasma atmosphere is generated by a direct plasma-generated process wherein plasma is directly generated in the reactor, or by a remote plasma-generated process wherein plasma is generated out of the reactor and supplied into the reactor.
